# FASCICULE DE BREVET EUROPEEN

(11) **EP 3 061 140 B1**
(45) Date de publication et mention de la délivrance du brevet: **29.11.2017**
(21) Numéro de dépôt: 14824887.5
(22) Date de dépôt: 23.10.2014
(51) Int. Cl.: H01L 41/00, H01L 41/06, H01L 41/113, H01L 41/12, H02N 2/18

(54) **CONVERTISSEUR D'UNE VARIATION D'ENERGIE A RECUPERER EN UNE DIFFERENCE DE POTENTIELS**
WANDLER ZUM UMWANDELN EINER SCHWANKUNG VON RÜCKZUGEWINNENDER ENERGIE IN EINE POTENZIALDIFFERENZ
CONVERTER FOR CONVERTING A VARIATION IN ENERGY TO BE RECOVERED INTO A POTENTIAL DIFFERENCE

(30) Priorité: 25.10.2013 FR 1360428
(43) Date de publication de la demande: 31.08.2016
(73) Titulaire: Commissariat à l'Energie Atomique et aux Energies Alternatives, 75015 Paris (FR); Institut Polytechnique de Grenoble, 38500 Grenoble (FR)
(72) Inventeur: VIALA, Bernard, F-38360 Sassenage (FR); DELAMARE, Jérome, F-38000 Grenoble (FR)
(74) Mandataire: Colombo, Michel
(86) Numéro de dépôt international: PCT/FR2014/052706
(87) Numéro de publication internationale: WO 2015/059421

(56) Documents cités:
- US-A- 5 739 601
- THOMAS LAFONT ET AL: "Paper;Magnetostrictive piezoelectric composite structures for energy harvesting;Magnetostrictive--piezoelectric composite structures for energy harvesting", JOURNAL OF MICROMECHANICS & MICROENGINEERING, INSTITUTE OF PHYSICS PUBLISHING, BRISTOL, GB, vol. 22, no. 9, 24 août 2012 (2012-08-24), page 94009, XP020228735, ISSN: 0960-1317, DOI: 10.1088/0960-1317/22/9/094009 cité dans la demande
- XIANZHI DAI ET AL: "Energy harvesting from mechanical vibrations using multiple magnetostrictive/piezoelectric composite transducers", SENSORS AND ACTUATORS A, ELSEVIER SEQUOIA S.A., LAUSANNE, CH, vol. 166, no. 1, 31 décembre 2010 (2010-12-31), pages 94-101, XP028142137, ISSN: 0924-4247, DOI: 10.1016/J.SNA.2010.12.025 [extrait le 2011-01-04]
- Xin-Jie Yu ET AL: "Wireless energy transfer system based on metglas/PFC magnetoelectric laminated composites", Acta Phys. Sin., 5 mars 2013 (2013-03-05), pages 058503-1, XP055122798, DOI: 10.7498/aps.62.058503 Extrait de l'Internet: URL:http://wulixb.iphy.ac.cn/CN/article/do wnloadArticleFile.do?attachType=PDF&id=524 31 [extrait le 2014-06-11]
- KIM S ET AL: "Piezoelectric energy harvesting using a clamped circular plate: Experimental study", AD / AEROSPACE DIVISION, AMERICAN SOCIETY OF MECHANICAL ENGINEERS, AMERICAN SOCIETY OF MECHANICAL ENGINEERS / AEROSPACE DIVISION, US, vol. 68, 1 janvier 2003 (2003-01-01), pages 461-469, XP009178481, ISSN: 0733-4230

## Description

L'invention concerne un convertisseur d'une variation d'énergie à récupérer en une différence de potentiels et un générateur d'électricité incorporant ce convertisseur.

Ici, par différence de potentiels, on désigne une tension entre deux bornes électriques, l'une de ces bornes électriques comportant un excédent de charges électriques par rapport à l'autre de ces bornes.

De tels convertisseurs connus comportent :
- un premier transducteur comportant une couche s'étendant essentiellement dans un plan, dit de référence, et se comportant mécaniquement comme un seul bloc de matière, cette couche étant apte à s'allonger à l'intérieur d'au moins une première zone de déformation du plan de référence et, simultanément, à rétrécir à l'intérieur d'au moins une seconde zone de déformation du plan de référence distincte de la première zone, en réponse à la même variation d'énergie à récupérer,
- un deuxième et un troisième transducteurs électromécaniques, chaque transducteur électromécanique comportant :
   - une couche en matériau piézoélectrique s'étendant essentiellement parallèlement au plan de référence et présentant des faces intérieure et extérieure s'étendant parallèlement à ce plan, la face intérieure étant fixée sans aucun degré de liberté sur la couche du premier transducteur pour subir une contrainte mécanique exercée par l'une des zones de cette couche, et
   - une première et une deuxième électrodes en matériau électriquement conducteur s'étendant essentiellement parallèlement au plan de référence le long d'au moins l'une des faces de la couche en matériau piézoélectrique du deuxième transducteur pour faire apparaître un excédent de charges électriques sur l'une de ces électrodes en réponse à la contrainte mécanique subie par la couche en matériau piézoélectrique.

De tels convertisseurs sont par exemple décrits dans la demande US2004126620A1. Le fonctionnement de ce type de convertisseur est également présenté dans les articles suivants :
- Article A1 : T. Lafont, J. Delamare, G. A. Lebedev, D. 1. Zakharov, B. Viala, O. Cugat, L. Gimeno, N. Galopin, L. Garbuio et O. Geoffroy, « Magnetostrictive-piezoelectric composite structures for energy harvesting », Journal of michromechanics and microengeneering, n°22, 2012. ;
- Article A2 : D. Zakharov, G. Lebedev, O. Cugat, J. Delamare, B. Viala, T. Lafont, L. Gimeno et A. Shelyakov, « Thermal energy conversion by coupled shape memory and piezoelectric effects », PowerMEMS'11, Séoul, Corée, JMM 2012 ;
- article A3 : G. A. LEBEDEV et AI, « Thermal energy harvesting using shape memory/piezoelectric composites », Transducer'11, Beijing, Chine, juin 5-9, 2011.

De l'état de la technique est également connu de :
- Xianzhi Dai et AL : « Energy harvesting from mechanical vibrations using multiple magnetostrictive/piezoelectric composite transducers », Sensor and Actuators A, Elsevier Sequoia S.A. Lausanne, CH, vol. 166, n°1, 31/12/2010, pages 94-101 ;
- Xin-Jie Yu et AL : « Wireless energy transfer system based on metglas/ PFC magnetoelectric laminated composites », 2013-03-05, Acta Phys. Sin., vol. 62, no. 5, 058503, p. 1-8, (2013) ;
- Kim S et AL : « Piezoelectric energy harvesting using a clamped circular plate: Experimental study », AD / Aerospace Division, American Society of mechanical engineers, vol. 68, 2003-01-01, pages 461-469.

L'invention vise à augmenter l'efficacité de ce type de convertisseur. L'efficacité est ici définie comme étant la quantité d'énergie électrique produite pour une même variation de l'énergie à récupérer.

L'invention a donc pour objet un tel convertisseur conforme à la revendication 1.

Par « polarisation de la couche en matériau piézoélectrique » on désigne la polarisation de cette couche qui a été créée pendant sa fabrication et qui existe même en absence d'application d'une contrainte mécanique sur cette couche. A cause de cela, cette polarisation est également appelée « pré-polarisation ». Elle détermine notamment sur quelle électrode du transducteur électromécanique va apparaître un excédent de charges électriques en réponse à une contrainte en tension appliquée sur la couche en matériau piézoélectrique.

Dans les convertisseurs connus, le transducteur électromécanique comprend, typiquement :
- une couche en matériau piézoélectrique qui s'étend à la fois sur les première et seconde zones de déformation, et
- une seule électrode qui recouvre toute la face extérieure de la couche en matériau piézoélectrique.

Ainsi, dans les convertisseurs connus, la couche en matériau piézoélectrique génère, au-dessus des premières zones de déformation, des charges électriques d'un premier signe et simultanément, au-dessus des secondes zones de déformation, des charges électriques d'un second signe opposé. Dans les convertisseurs connus, la même électrode recouvre toute la face extérieure de la couche piézoélectrique. Ainsi, les charges électriques générées au-dessus des secondes zones viennent annuler des charges générées au-dessus des premières zones. Cela réduit d'autant la différence de potentiels générée par les convertisseurs connus en réponse à une variation de l'énergie à récupérer et donc l'efficacité de tels convertisseurs.

Les déposants ont découvert ce phénomène et l'ont exploité pour, au contraire, accroître l'efficacité du convertisseur. Ainsi, le convertisseur revendiqué comporte non pas un mais au moins deux transducteurs électromécaniques distincts. Ces transducteurs électromécaniques sont disposés par rapport au premier transducteur pour exploiter séparément ses première et seconde zones de déformations. Dès lors, les charges électriques générées par le troisième transducteur ne viennent plus en déduction des charges générées par le deuxième transducteur. Ceci permet d'augmenter l'efficacité du convertisseur. De plus, il est possible de raccorder électriquement entre elles les électrodes des transducteurs électromécaniques de manière à augmenter l'énergie récupérée, et ainsi augmenter encore plus l'efficacité du convertisseur.

Les modes de réalisation de ce convertisseur peuvent comporter une ou plusieurs des caractéristiques des revendications dépendantes.

Ces modes de réalisation du convertisseur présentent en outre les avantages suivants :
- utiliser des transducteurs électromécaniques, dont les couches en matériau piézoélectrique présentent des directions de polarisation opposées, disposés sur une même face du premier transducteur, permet de simplifier le raccordement électrique de ce convertisseur, car toutes les charges générées d'un même côté du convertisseur sont du même signe ;
- utiliser une électrode commune pour les premier et deuxième transducteurs électromécaniques permet de simplifier la fabrication du convertisseur ;
- empiler un quatrième transducteur similaire au premier transducteur sur la face extérieure des couches en matériau piézoélectrique des deuxième et troisième transducteurs, permet d'augmenter l'efficacité du convertisseur,
- réaliser des cloisons fines entre les différentes couches de matériau piézoélectriques, c'est-à-dire des cloisons dont l'épaisseur est essentiellement inférieure à l'épaisseur de la couche en matériau piézoélectrique, permet d'augmenter l'efficacité du convertisseur notamment quand ce dernier est de très petites dimensions;
- mettre en oeuvre des deuxième et troisième transducteurs qui recouvrent ensemble quasiment la totalité de la surface des première et seconde zones de déformation permet d'augmenter l'efficacité du convertisseur ;
- disposer des exemplaires du deuxième et du troisième transducteurs de façon symétrique par rapport à un plan médian du premier transducteur, permet de limiter la flexion du convertisseur dans des directions perpendiculaires à ce plan de symétrie ;
- utiliser un premier transducteur en forme de disque permet de produire de l'énergie électrique de manière efficace à partir d'un mouvement de rotation d'un aimant permanent par rapport au convertisseur.

L'invention a également pour objet un générateur d'électricité comportant le convertisseur ci-dessus.

Les modes de réalisation de ce générateur peuvent comporter une ou plusieurs des caractéristiques des revendications dépendantes.

L'agencement des aimants permanents pour que leurs projections orthogonales dans le plan de référence soient orthogonales accroît l'efficacité du convertisseur. En effet, cela permet d'augmenter le rétrécissement à l'intérieur de la seconde zone de déformation par rapport au cas où le second aimant permanent serait absent.

L'invention sera mieux comprise à la lecture de la description qui va suivre, donnée uniquement à titre d'exemple non limitatif et faite en se référant aux dessins sur lesquels :
- la figure 1 est une illustration schématique, partiellement en coupe verticale, d'un générateur d'électricité utilisant pour cela un récupérateur d'énergie ;
- la figure 2A est une illustration schématique, en coupe verticale, d'un premier mode de réalisation d'un convertisseur d'énergie utilisé dans le récupérateur d'énergie de la figure 1 ;
- la figure 2B est une illustration schématique, en vue de dessus, d'une couche en matériau magnétostrictif utilisée dans le convertisseur de la figure 2A ;
- la figure 3 est une illustration schématique en vue de dessus, du convertisseur de la figure 2A ;
- la figure 4 est une illustration schématique, en vue de dessus, d'un autre mode de réalisation du convertisseur de la figure 3 ;
- la figure 5 est une illustration schématique d'un autre mode de réalisation d'un générateur d'électricité utilisant plusieurs aimants permanents;
- la figure 6 est une illustration schématique, en vue de dessus, des zones de déformations d'une couche en matériau magnétostrictif utilisée dans le générateur de la figure 5 ;
- la figure 7 est une illustration schématique, en vue de dessus, d'un ensemble d'aimants permanents pour le générateur d'électricité de la figure 5 ;
- la figure 8 est une illustration schématique, en vue de dessus, d'un ensemble d'aimants permanents pour le générateur de la figure 1;
- la figure 9 est une illustration schématique d'un autre mode de réalisation d'un générateur d'électricité utilisant un champ magnétique déplaçable en translation;
- la figure 10 est une illustration schématique d'un autre mode de réalisation d'un générateur d'électricité utilisant une variation de température ;
- la figure 11 est une illustration schématique, en vue de dessus, d'un autre mode de réalisation d'un ensemble d'aimants permanents pour le générateur de la figure 5 ;
- les figures 12 et 13 sont des illustrations schématiques, en coupe verticale, d'autres modes de réalisation du convertisseur de la figure 2A.

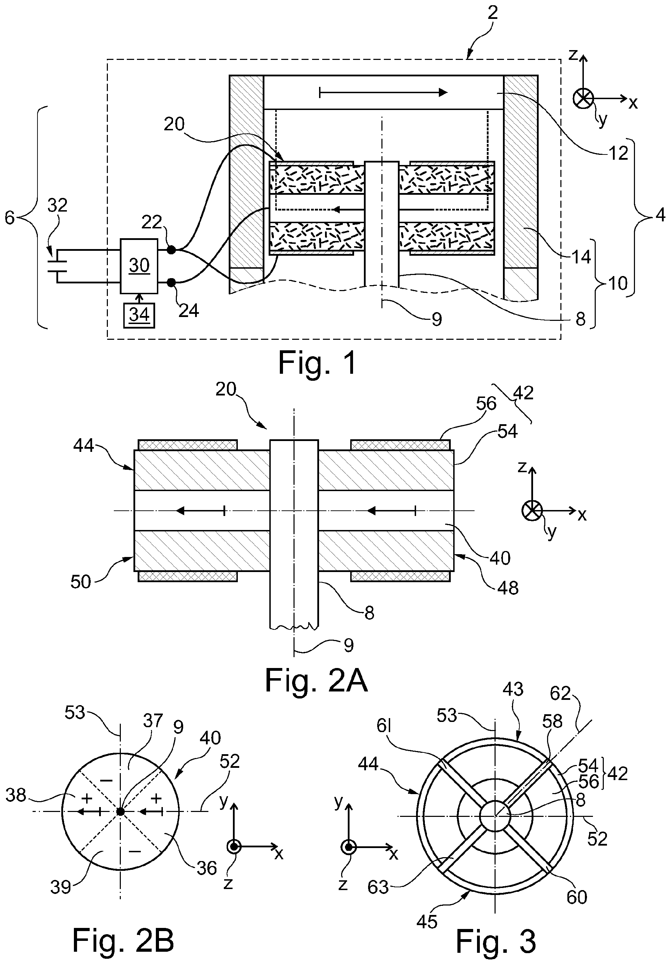

La figure 1 représente un générateur 2 d'électricité. Ce générateur 2 comporte :
- une source 4 d'énergie à récupérer, et
- un récupérateur 6 d'énergie propre à transformer une variation de l'énergie à récupérer en électricité.

Ici, le générateur 2 est décrit dans le cas particulier où l'énergie à récupérer est un champ magnétique variable.

Plus précisément, dans ce mode de réalisation, le champ magnétique variable est un champ magnétique rotatif dont le moment magnétique lui donnant naissance tourne sur lui-même. A cet effet, la source 4 comprend :
- un appareil 10 muni d'un arbre 8 entraîné en rotation sur lui-même autour d'un axe vertical 9, et
- un aimant permanent 12 fixé sans aucun degré de liberté sur un châssis 14 immobile de cet appareil 10 à proximité de l'extrémité distale de l'arbre 8.

Sur la figure 1 et les figures suivantes, la direction verticale est repérée par une direction Z d'un repère orthogonal XYZ. Les directions X et Y de ce repère XYZ sont donc horizontales. Par la suite, les termes « dessus », « dessous », « inférieure », « supérieure » sont définis par rapport à la direction Z.

Par exemple, l'appareil 10 est un compteur de liquide ou de gaz et l'arbre 8 est l'arbre de cet appareil 10 entraîné en rotation par le liquide ou le gaz consommé. Pour simplifier la figure, seule une partie de l'appareil 10 a été représentée.

L'aimant permanent 12 est un aimant permanent uni-axial ayant un moment magnétique parallèle à la direction X. Un aimant permanent uni-axial est un aimant permanent qui présente un seul moment magnétique dans une seule direction.

Le récupérateur 6 comporte un convertisseur 20 qui convertit le champ magnétique variable en un excédent correspondant de charges électriques sur une borne 22 ou 24 de raccordement. L'excédent se mesure ici par rapport à l'autre des bornes 22 ou 24. Ce convertisseur 20 est fixé sans aucun degré de liberté sur l'extrémité distale de l'arbre 8. Ainsi, dans ce mode de réalisation, le champ magnétique rotatif est obtenu en faisant tourner le convertisseur 20 sur lui-même et non pas l'aimant 12. Le raccordement électrique du convertisseur 20 aux bornes 22, 24 se fait par l'intermédiaire d'un dispositif conventionnel de raccordement électrique d'une pièce tournante à des bornes électriques fixes.

Le récupérateur 6 comporte également :
- un circuit 30 de collecte de l'excédent de charges électriques sur la borne 22 ou 24 et de transfert de ces charges électriques collectées vers un équipement électrique 32, et
- un circuit 34 de commande du circuit 30.

Par exemple, l'équipement 32 est un condensateur qui stocke l'énergie récupérée. Le circuit 30 de collecte et le circuit 34 de commande sont par exemple identiques à ceux décrits dans la demande de brevet WO 2007/063194 et, de préférence, identiques à l'un de ceux décrits dans la demande déposée sous le n° FR 1260047, le 22 octobre 2012 par le Commissariat à l'énergie atomique et aux énergies alternatives. Par conséquent, ces circuits 30 et 34 ne sont pas décrits ici plus en détail.

Les figures 2A, 2B et 3 représentent plus en détail le convertisseur 20.

Le convertisseur 20 est capable de transformer en électricité des variations très lentes de l'énergie à récupérer. Par « variation lente », on désigne des variations dont la fréquence fondamentale est inférieure à 10 Hz. A cet effet, le convertisseur 20 convertit une variation de l'amplitude du champ magnétique variable dans une direction donnée en une génération d'un excédent de charges sur la borne 22 et, en alternance, sur la borne 24. Cette conversion se fait presque instantanément de sorte que la tension entre les bornes 22 et 24 varie en même temps et au fur et à mesure que l'amplitude du champ magnétique variable varie dans une direction donnée.

Le convertisseur 20 comporte un transducteur magnétique associé à des transducteurs électromécaniques. Le transducteur magnétique est une couche 40 de matériau magnétostrictif. La couche 40 est réalisée dans un matériau magnétostrictif dont la valeur absolue, à saturation, du coefficient de magnétostriction λₛ est supérieure à 10 ppm (partie par million) et de préférence supérieure à 100 ou 1000 ppm. Le coefficient λₛ est défini par la relation suivante : λₛ = ΔL/L, où :
- ΔL est le taux d'élongation du matériau magnétostrictif, par exemple, le long de son axe préférentiel de déformation, et
- L est la longueur de ce matériau le long de cet axe en absence de champ magnétique extérieur.

L'axe préférentiel de déformation est l'axe le long duquel l'amplitude de la déformation de la couche en matériau magnétostrictif est maximale lorsqu'elle est traversée par des lignes de champ parallèles à cet axe.

Ici le coefficient λₛ est positif. Par exemple, le matériau magnétostrictif est le Terfenol-D ou le FeSiB ou un alliage de FeCo ou un composite dérivé.

Ici, la couche 40 est formée d'un seul bloc de matière. Cette couche 40 a la forme d'un disque horizontal. Ce disque est centré sur l'axe 9 et présente des faces planes horizontales de chaque côté appelées par la suite, respectivement, « de dessus » et « de dessous ». Sur les figures 2A et 2B, la direction des lignes de champ générées par l'aimant 12 à l'intérieur de la couche 40 sont représentées par des flèches. Les lignes de champs à l'intérieur de la couche 40 s'étendent parallèlement à la direction X.

La couche 40 présente quatre zones 36 à 39 (Figure 2B) de déformation distinctes. Dans la position de la figure 2B, à l'intérieur des zones 36 et 38, la couche 40 s'allonge le long d'un axe 52 parallèle à la direction X beaucoup plus qu'elle ne rétrécit dans la direction Y. Simultanément, à l'intérieur des zones 37 et 39, la couche 40 se rétrécie le long d'un axe 53 parallèle à la direction Y beaucoup plus qu'elle ne s'allonge dans la direction X. Par « beaucoup plus », on désigne le fait que l'amplitude de la déformation dans une direction est au moins deux ou cinq ou dix fois supérieure à l'amplitude de la déformation dans la direction orthogonale. Ces axes 52, 53 se coupent en un point situé sur l'axe 9 de l'arbre 8.La forme des zones 36 à 39 dépend notamment de la forme de la couche 40. Sur la figure 2B, elles sont séparées les unes des autres par des lignes en pointillé. Par exemple, le long de ces lignes en pointillé, la longueur de la couche 40 est la même qu'en absence de champ magnétique. Dans le cas décrit ici, où la couche 40 a la forme d'un disque, chaque zone 36 à 39 est un secteur angulaire respectif du disque dont l'angle au sommet est situé sur l'axe 9. La valeur de l'angle au sommet est égale à 90°. Plus précisément, dans la position de la figure 2B, l'axe 52 forme la bissectrice des zones 36 et 38 et l'axe 53 forme la bissectrice des deux autres zones 37 et 39.

Dans ce mode de réalisation, le convertisseur 20 comporte également pour chaque zone de déformation et sur chaque face de la couche 40, un transducteur électromécanique. Ici, le convertisseur 20 comporte :
- quatre transducteurs électromécaniques 42 à 45 (figure 3) fixés sans aucun degré de liberté sur la face de dessus de la couche 40, et
- quatre transducteurs électromécaniques fixés sans aucun degré de liberté sur la face de dessous de la couche 40.

Sur la figure 2A, seuls les transducteurs 42 et 44 de dessus et deux transducteurs 48 et 50 de dessous sont visibles. Les transducteurs « de dessous », c'est-à-dire fixés sur la face de dessous de la couche 40, sont les symétriques des transducteurs « de dessus », c'est-à-dire les transducteurs 42 à 45, par rapport à un plan horizontal médian passant à mi-hauteur de la couche 40. Par conséquent, par la suite, les transducteurs de dessous ne sont pas décrits en détail.

Les transducteurs 42 à 45 sont agencés les uns par rapport aux autres pour qu'il existe au moins une position angulaire du convertisseur 20 par rapport à l'aimant 12, dans laquelle les transducteurs 42 à 45 sont uniquement disposés, respectivement, au-dessus des zones 36 à 39. Un exemple d'une telle position angulaire particulière est représenté sur la figure 3. A cet effet, dans la position de la figure 3, les transducteurs 42 et 44 sont fixés l'un après l'autre le long de l'axe 52 et de part et d'autre de l'axe 53. Les transducteurs 43 et 45 sont disposés l'un après l'autre le long de l'axe 53 et de part et d'autre de l'axe 52. Le plan vertical passant par l'axe 52 forme un plan de symétrie pour tous les transducteurs du dessus. De même, le plan vertical passant par l'axe 53 forme un plan de symétrie pour l'ensemble des transducteurs du dessus.

Dans ce mode de réalisation, les transducteurs 42 à 45 sont structurellement identiques et diffèrent uniquement les uns des autres par leur position le long des axes 52 et 53. Ainsi, par la suite, seul le transducteur 42 va maintenant être décrit plus en détail.

Le transducteur 42 comporte:
- une couche 54 en matériau piézoélectrique,
- une électrode extérieure 56, et
- une électrode intérieure.

La couche 54 comporte une face intérieure horizontale directement fixée sans aucun degré de liberté sur la face du dessus de la couche 40 et une face extérieure horizontale située du côté opposé. L'épaisseur de cette couche 54 mesurée le long de la direction Z est par la suite notée « e ».

Par exemple, le coefficient de couplage k du matériau piézoélectrique de la couche 54 est supérieur à 5 % ou 10 %. Ce coefficient de couplage est défini dans la norme ANSI/IEEE 176-1987 « ANSI/IEEE standard on piezoelectricity » ou dans les normes de la famille EN50324. De préférence, le coefficient g₃₁ de ce matériau piézoélectrique est supérieur à 5*10⁻³ Vm/N ou 10*10⁻³ Vm/N et, avantageusement, supérieur à 100*10⁻³ Vm/N ou 200*10⁻³ Vm/N à 25°C. Par exemple, le matériau piézoélectrique de la couche 54 est du PZT (Titano-Zyrconate de Plomb) ou du PMN-PT (lead magnésium niobate-lead titanate).

Ici, lors de sa fabrication, chaque matériau piézoélectrique est polarisé par un fort champ électrique de manière à présenter une polarisation perpendiculaire à ses faces intérieure et extérieure. Ici, les sens de polarisation des couches piézoélectriques des transducteurs 42 et 44 sont identiques. Par contre, les sens de polarisation des couches en matériau piézoélectrique des transducteurs 43 et 45 sont parallèles mais de direction opposée à celle de la couche 54.

La couche 54 est séparée mécaniquement des couches en matériau piézoélectrique des autres transducteurs 43 à 45 immédiatement adjacents, par des cloisons, respectivement, 58 et 60 (figure 3).

Les cloisons 58 et 60 sont conformées pour que la couche 54 s'étende essentiellement sur la zone 36 de la couche 40 dans la position de la figure 3. Dans le cas décrit ici, la couche 54 s'étend uniquement sur la zone 36. Dans ces conditions, dans la position de la figure 3, la couche 40 exerce principalement une contrainte en tension sur le transducteur 42. Ici, la cloison 58 s'étend de façon rectiligne le long d'un axe horizontal 62 coupant l'axe 9 et incliné de 45° par rapport à l'axe 52. La cloison 60 est le symétrique de la cloison 58 par rapport au plan vertical passant par l'axe 52. Cette cloison 60 n'est donc pas décrite plus en détail.

La cloison 58 est dépourvue de matériau piézoélectrique. Par exemple, elle est formée par une tranchée remplie d'un matériau électriquement isolant. Ici, un matériau est considéré comme électriquement isolant si sa résistivité est supérieure à 10² Ω.m et, de préférence, supérieure à 10⁵ Ω.m ou 10¹⁵ Ω.m à 25°C.

Ici, la largeur de la cloison 58 mesurée le long d'une direction horizontale orthogonale à l'axe 62 est constante. Par exemple, cette largeur est inférieure à 2e et avantageusement inférieure à e ou à e/2 ou à e/10.

Ainsi, dans ce mode de réalisation, la couche 54 occupe plus de 80 % ou 90 % de la surface de la zone 36 de la couche 40 située dessous dans la position de la figure 3.

Des cloisons 61, 63 délimitent la couche en matériau piézoélectrique du transducteur 44. Ces cloisons 61, 63 sont, respectivement, les symétriques des cloisons 58, 60 par rapport au plan vertical passant par l'axe 53. Ces cloisons 61, 63 sont conformées pour que la couche en matériau piézoélectrique du transducteur 44 s'étende seulement sur la zone 38 dans la position de la figure 3. Les cloisons 58, 61 délimitent aussi le matériau piézoélectrique du transducteur 43 et les cloisons 60, 63 délimitent aussi le matériau piézoélectrique du transducteur 45. Ainsi, le matériau piézoélectrique des transducteurs 43, 45 s'étend uniquement sur, respectivement, les zones 37 et 39 dans la position de la figure 3.

L'électrode 56 est réalisée dans un matériau électriquement conducteur. Ici, on considère qu'un matériau est électriquement conducteur si sa résistivité à 25°C est inférieure à 10⁻⁵ Ω.m et avantageusement inférieure à 10⁻⁶ Ω.m ou 10⁻⁷ Ω.m.

L'électrode 56 est directement déposée sur la face extérieure de la couche 54. Typiquement, elle recouvre la majorité de cette face extérieure et, de préférence, plus de 70 % ou 80 % de cette face extérieure.

Dans ce mode de réalisation, l'électrode 56 est commune à l'ensemble des transducteurs 42 à 45. Elle recouvre donc également plus de 70 % ou 80 % des faces extérieures des couches en matériau piézoélectrique des transducteurs 43 à 45 pour former également les électrodes de ces transducteurs. Par exemple, l'électrode 56 est réalisée dans une couche d'un seul tenant en matériau électriquement conducteur qui recouvre la majorité des faces extérieures des transducteurs 42 à 45. Sur la figure 3, l'électrode 56 n'a pas été représentée au-dessus des cloisons 58, 60, 61, 63 pour rendre ces cloisons plus visibles.

Dans le cas particulier décrit ici, la couche 40 est également électriquement conductrice. Dans ces conditions, la couche 40 remplit également la fonction d'électrode intérieure pour chacun des transducteurs 42 à 45.

La couche 54 est utilisée dans un mode de fonctionnement où l'excédent de charges électriques est créé entre les faces horizontales intérieure et extérieure de cette couche. En effet, lorsque le convertisseur 20 est utilisé pour générer de l'électricité, il est préférable de maximiser la capacité de chacun des transducteurs 42 à 45. On utilise donc ici le mode d₃₁ de la couche 54 et non pas son mode d₃₃._{.}

Lors du fonctionnement du convertisseur 20, puisque l'aimant 12 est uni-axial, dans la première position de la figure 3, l'allongement de la couche 40 est maximal le long de l'axe 52 et, simultanément, le rétrécissement de cette couche 40 est maximal le long de l'axe 53. Dans cette première position, les zones 36 et 38 exercent principalement une contrainte en tension dans la direction X sur les transducteurs 42 et 44 et les zones 37, 39 exercent principalement une contrainte en compression sur les transducteurs 43 et 45. Dès lors, à cause de l'inversion du sens de polarisation des couches en matériau piézoélectrique des transducteurs 42, 44 par rapport à celui des transducteurs 43 et 45, dans la première position, les couches en matériau piézoélectrique des transducteurs 42 à 45 génèrent toutes des charges de même signe sur l'électrode 56. On obtient dans cette première position un maximum de la différence de potentiels entre les bornes 22 et 24. Lorsque le convertisseur 20 tourne de 90° par rapport à la position de la figure 3, les transducteurs 42 et 44 sont entièrement situés au-dessus des zones 37 et 39 et les transducteurs 43 et 45 sont entièrement situés au-dessus des zones 36 et 38. Dans cette seconde position, les transducteurs 42 à 45 génèrent simultanément un maximum de charges électriques de même signe mais opposé à celui correspondant à la position de la figure 3. On obtient alors un minimum de la différence de potentiels entre les bornes 22 et 24.

La structure du convertisseur 20 permet donc d'exploiter simultanément les zones de la couche 40 exerçant une contrainte en tension et les zones de la couche 40 exerçant une contrainte en compression pour augmenter l'excédent de charges électriques généré. Ceci permet d'accroître l'efficacité du convertisseur 20 d'au moins 20 % ou 30 % par rapport à un convertisseur identique mais dans lequel les couches en matériau piézoélectrique des transducteurs 42 à 45 auraient toutes le même sens de polarisation.

On notera aussi que puisque le convertisseur 20 tourne par rapport à l'aimant permanent 12, chaque transducteur génère, en alternance, un excédent de charge positive puis un excédent de charge négative au fur et à mesure de la rotation du convertisseur 20 par rapport à l'aimant 12.

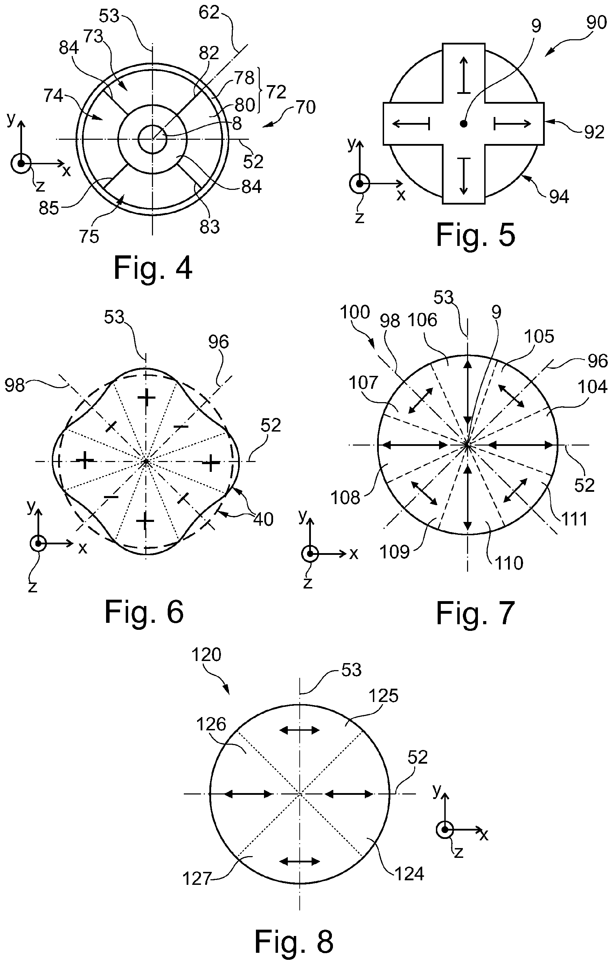

La figure 4 représente un convertisseur 70 susceptible d'être utilisé à la place du convertisseur 20 dans le récupérateur 6 d'énergie.

Ce convertisseur 70 est identique au convertisseur 20 sauf que les transducteurs 42 à 45 sont remplacés, respectivement, par des transducteurs 72 à 75.

Comme dans le mode de réalisation précédent, les transducteurs de dessous se déduisent des transducteurs 72 à 75 de dessus par symétrie par rapport à un plan horizontal médian situé à mi-hauteur de la couche 40.

Dans ce mode de réalisation, les transducteurs 72 à 75 sont disposés les uns par rapport aux autres de manière à ce qu'il existe au moins une position angulaire de ce convertisseur par rapport à l'aimant 12 dans laquelle les transducteurs 72 à 75 sont uniquement disposés, respectivement, sur les zones 36 à 39 de la couche 40. Un exemple d'une telle position est représenté sur la figure 4. A cet effet, les deux plans verticaux passant par les axes 52 et 54 forment des plans de symétrie pour l'ensemble de ces transducteurs 72 à 75. Puisque les transducteurs 72 à 75 sont structurellement identiques, seul le transducteur 72 va maintenant être décrit plus en détail.

Le transducteur 72 comporte une couche 78 en matériau piézoélectrique identique à la couche 54 sauf qu'elle s'étend uniformément sur toute la face de dessus de la couche 40. Par conséquent, la couche 78 forme également la couche en matériau piézoélectrique des transducteurs 73 à 75. Ainsi, dans ce mode de réalisation, les couches en matériau piézoélectrique des différents transducteurs 72 à 75 ne sont pas isolées mécaniquement les unes des autres par des cloisons. De plus, dans ce mode de réalisation, les sens de polarisation des couches en matériau piézoélectrique des transducteurs 72 à 75 sont tous identiques.

Le transducteur 72 comporte également une électrode extérieure 80 directement déposée sur la face extérieure de la couche 78. Cette électrode 80 est identique à l'électrode 56 sauf qu'elle est séparée mécaniquement des électrodes des autres transducteurs 73 à 75 par des séparations 82 à 85. Ces séparations 82 à 85 sont dépourvues de matériau électriquement conducteur. Ainsi ces séparations isolent électriquement l'électrode 80 des électrodes des autres transducteurs 73 à 75. Par exemple, ces séparations 82 et 83 sont formées par des tranchées remplies d'un matériau électriquement isolant sous forme gazeuse, tel que de l'air, ou solide.

Les séparations 82 et 83 sont conformées pour que l'électrode 80 s'étende uniquement au-dessus de la zone 36 de la couche 40 dans la position de la figure 4. A cet effet, la séparation 82 s'étend le long de l'axe 62 et la séparation 83 est le symétrique de la séparation 82 par rapport à un plan vertical passant par l'axe 52.

Comme précédemment, de préférence, la largeur de la séparation 82 mesurée dans une direction perpendiculaire à l'axe 62 est inférieure à 2e et, de préférence, inférieure à e ou à e/2 ou à e/10.

Les séparations 84, 85 sont les symétriques des séparations 82, 83 par rapport au plan vertical passant par l'axe 53. De cette manière, dans la position de la figure 4, les transducteurs 73 et 75 sont uniquement soumis à une contrainte en compression quand les transducteurs 72, 74 sont uniquement soumis à une contrainte en tension et vice versa.

La couche 40 forme une électrode intérieure commune aux transducteurs 72 à 75.

Dans ce mode de réalisation, étant donné que la direction de polarisation est la même pour chaque transducteur 72 à 75, lorsque la couche 40 s'allonge le long de l'axe 52, une contrainte en tension s'exerce sur des portions de la couche 78 situées sur les zones 36 et 38 et, simultanément, une contrainte en compression s'exerce sur les portions de la couche 78 situées sur les zones 37 et 39. Ainsi, un excédent de charges électriques, par exemple positives, apparaît sur les électrodes extérieures des transducteurs 72 et 74 et, simultanément, un excédent de charges électriques négatives apparaît sur les électrodes extérieures des transducteurs 73 et 75. Toutefois, cette production de charges négatives ne vient pas en diminution de la production de charges positives car les électrodes extérieures des transducteurs 72 et 74 sont électriquement isolées des électrodes extérieures des transducteurs 73 et 75. Au contraire, cet excédent de charges positives d'un côté, et négatives de l'autre côté, est ici exploité en raccordant électriquement et en permanence les électrodes extérieures des transducteurs 72 et 74 uniquement à la borne 22 et les électrodes extérieures des transducteurs 73 et 75 uniquement à la borne 24. Cela permet d'obtenir, dans la position de la figure 4, une différence de potentiels plus grande que si les électrodes extérieures des transducteurs 72 à 75 étaient remplacées par une seule électrode extérieure commune. Cela permet donc d'accroître l'efficacité du convertisseur 70.

La figure 5 représente un générateur 90 d'électricité. Ce générateur 90 est identique au générateur 2 sauf que :
- l'aimant permanent 12 est remplacé par un ensemble 92 d'aimants permanents,
- le convertisseur 20 est remplacé par un convertisseur 94.

Sur la figure 5, pour simplifier, seuls les éléments du générateur 90 différents de ceux du générateur 2 ont été représentés.

L'ensemble 92 présente quatre moments magnétiques horizontaux uniformément répartis autour de l'axe 9. Sur la figure 5, deux de ces moments magnétiques sont alignés sur la direction X et de sens opposé. Les deux autres moments magnétiques sont alignés sur la direction Y et de sens opposé. Par exemple, l'ensemble 92 est obtenu par assemblage de quatre aimants permanents uni-axiaux.

Le convertisseur 94 est identique au convertisseur 20 sauf qu'il existe un plus grand nombre de zones de déformation dans la couche 40 aptes à exercer principalement soit une contrainte en tension soit une contrainte en compression. Il existe donc un plus grand nombre de transducteurs électromécaniques sur chacune des faces de cette couche 40. Ces zones de déformation et l'emplacement des transducteurs sur la face de dessus de la couche 40 vont maintenant être décrits en référence à la figure 6.

La périphérie de la couche 40, en vue de dessus, en absence de champ magnétique généré par l'ensemble 92, est représentée en pointillés sur la figure 6. Ici elle a la forme d'un cercle centré sur l'axe 9.

La couche 40, en présence du champ magnétique généré par l'ensemble 92 lorsqu'il est dans la position représentée sur la figure 5, est représentée en trait plein sur la figure 6. Sur cette figure, la déformation de la couche 40 a été exagérée. En réalité, elle peut être inférieure à 100 µm ou 10 µm.

Dans la configuration représentée sur la figure 6, la couche 40 s'allonge simultanément le long des axes 52 et 53 et, en même temps, se rétrécit le long des axes horizontaux 96 et 98. Ces axes 96 et 98 sont orthogonaux entre eux et décalés angulairement de 45° par rapport aux axes 52 et 53. Il existe donc huit zones distincts de déformation dans ce mode de réalisation. Dans la position de la figure 5, les zones qui exercent principalement une contrainte en tension sur les transducteurs électromécaniques sont situées le long des axes 52 et 53 et les zones qui exercent principalement une contrainte en compression sont situées le long des axes 96 et 98. Sur la figure 6, les huit zones de déformation sont délimitées par des traits pointillés. De plus, les zones qui exercent une contrainte en tension sont repérées par le symbole « + » et celles qui exercent une contrainte en compression sont repérées par un symbole « - ».

Sur chacune des zones de déformation, on forme un transducteur conformément à l'enseignement donné en référence aux figures 2A, 2B et 3 ou conformément à l'enseignement donné en référence à la figure 4.

Dans le cas où l'on applique l'enseignement des figures 2A, 2B et 3, les cloisons entre les couches piézoélectriques des différents transducteurs de dessus sont formées, typiquement, le long des lignes en pointillés délimitant les différentes zones de déformation de la couche 40. Dans le cas où l'on applique l'enseignement donné en référence à la figure 4, les séparations entre les électrodes extérieures des différents transducteurs sont formées, typiquement, le long des lignes en pointillés délimitant ces différentes zones de déformation.

Au fur et à mesure de la rotation du convertisseur 94, chaque transducteur électromécanique est en alternance soumis principalement à une contrainte en tension puis principalement à une contrainte en compression.

La figure 7 représente un ensemble 100 d'aimants permanents susceptible d'être utilisé à la place de l'ensemble 92 dans le générateur 90. Cet ensemble 100 a la forme d'un disque horizontal centré sur l'axe 9. Ce disque est découpé en huit secteurs angulaires aimantés 104 à 111 successifs en allant dans le sens inverse des aiguilles d'une montre. L'angle au sommet de chaque secteur angulaire est situé sur l'axe 9. Ces secteurs 104 à 111 sont uniformément répartis autour de l'axe 9. Ils présentent chacun un angle au sommet de 60° situé sur l'axe 9. Dans la position représentée sur la figure 7, les plans verticaux passant par les axes 52, 53, 96 et 98 sont des plans de symétrie de l'ensemble 100. Chaque secteur aimanté 104 à 111 comprend au moins un aimant permanent uni-axial. Sur la figure 7, les moments magnétiques sont représentés par des doubles flèches. En effet, dans cette application, le sens du moment magnétique a peu d'importance car un matériau magnétostrictif est uniquement sensible à la direction du champ magnétique mais pas à son sens. Dans la position angulaire représentée sur la figure 7, les moments magnétiques des aimants permanents des secteurs 104 et 108 sont parallèles à l'axe 52. De façon similaire, les moments magnétiques des aimants permanents des secteurs 106 et 110 sont parallèles à l'axe 53. Les moments magnétiques des aimants permanents des secteurs 105 et 109 sont perpendiculaires à l'axe 96. Enfin, les moments magnétiques des aimants permanents des secteurs 107 et 111 sont perpendiculaires à l'axe 98. Le générateur équipé de l'ensemble 100 fonctionne comme le générateur 90 sauf que la présence d'aimants dont le moment magnétique est perpendiculaire aux axes 96, 98 augmente la contrainte en contraction exercée sur les transducteurs électromécaniques situés au-dessus des zones de la couche 40 repérées par le symbole « - » dans la figure 6. Cela permet d'augmenter encore plus l'efficacité du convertisseur.

La figure 8 représente un ensemble 120 d'aimants permanent identique à l'ensemble 100 sauf qu'il que ne comporte que quatre secteurs angulaires aimantés 124 à 127 uniformément répartis autour de l'axe 9. Dans la position représentée, les moments magnétiques des secteurs 124 et 126 sont parallèles à l'axe 52 et les moments magnétiques des secteurs 125 et 127 sont perpendiculaires à l'axe 53. Cet ensemble 120 fonctionne comme l'ensemble 100 mais est destiné à remplacer l'aimant 12 du générateur 2 d'électricité. Ainsi, dans la position représentée dans cette figure, la présence des aimants 125 et 127 au-dessus des zones 37 et 39 permet d'augmenter la contrainte en compression exercées par la couche 40 sur les transducteurs 43 et 45. En effet, comme dans le mode de réalisation précédent, les lignes de champ générées par les aimants 125 et 127 tendent à rétrécir la couche 40 le long de l'axe 53 dans les zones 37 et 39.

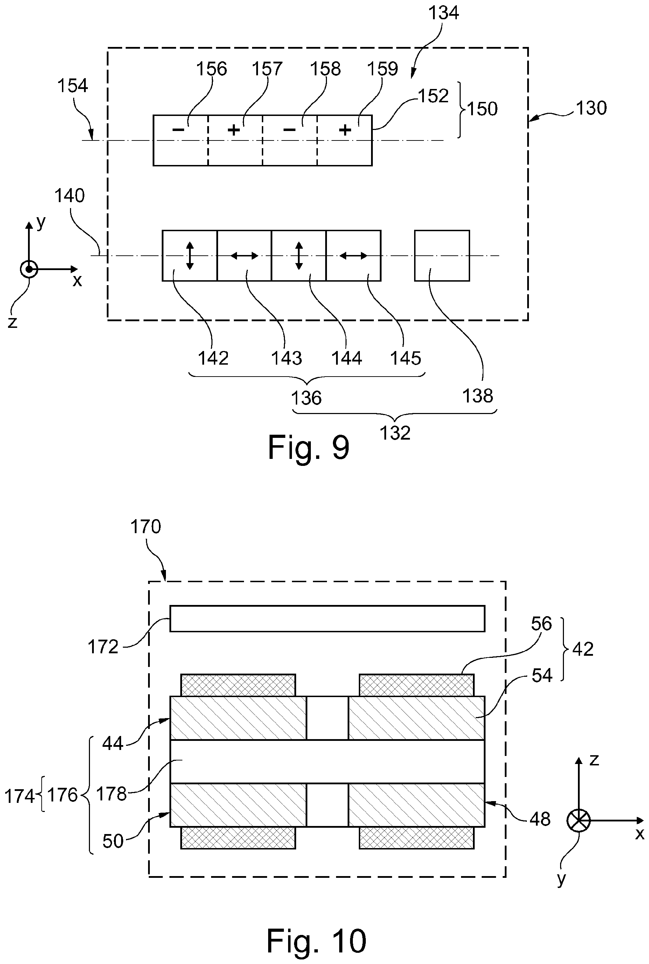

La figure 9 représente un générateur 130 d'électricité. Ce générateur 130 comporte :
- une source 132 de champ magnétique variable, et
- un récupérateur 134 d'énergie.

La source 132 comprend un ensemble 136 d'aimants permanents fixés les uns aux autres sans aucun degré de liberté et un dispositif 138 qui déplace en translation l'ensemble 136 parallèlement à la direction X. Ici, le dispositif 138 déplace l'ensemble 136 selon un mouvement de va-et-vient le long d'un axe horizontal 140. Ainsi, dans ce mode de réalisation, le champ magnétique variable n'est pas un champ magnétique rotatif.

L'ensemble 136 comprend une succession d'aimants permanents uni-axiaux alignés les uns après les autres le long de l'axe 140. Dans cet exemple, seul quatre aimants permanents uni-axiaux, numérotés de gauche à droite 142 à 145, sont représentés. Chacun de ces aimants permanents présente un moment magnétique représenté par une double flèche sur la figure 9. Ces aimants permanents sont agencés les uns par rapport aux autres de manière à ce que, en allant de la gauche vers la droite, le long de l'axe 140, les directions des moments magnétiques alternent entre des directions parallèles aux directions X et Y. Ainsi, sur la figure 9, le moment magnétique des aimants 142 et 144 est parallèle à la direction Y tandis que le moment magnétique des aimants 143 et 145 est parallèle à la direction X. Ici, la largeur des aimants 142 à 145 le long de l'axe 140 est la même quel que soit l'aimant considéré.

Le récupérateur 134 est identique au récupérateur 6 sauf que le convertisseur 20 est remplacé par un convertisseur 150. Comme dans les modes de réalisation précédents, le convertisseur 150 comprend un couche horizontale 152 en matériau magnétostricif, dessus et dessous laquelle sont fixés des transducteurs électromécaniques. Pour simplifier la figure 9, seule la couche 152 du convertisseur 150 a été représentée. De plus, dans la figure 9, pour que la couche 152 soit visible, elle a été représentée à côté de l'ensemble 136. Toutefois, dans la réalité, le convertisseur 150 et la couche 152 sont situés à la verticale de l'ensemble 136 dans la position représentée sur cette figure.

Ici, le convertisseur 150 est fixe dans le repère XYZ.

La couche 152 s'étend principalement le long d'un axe horizontal 154 parallèle à l'axe 140. Par exemple, la couche 152 est rectangulaire. Elle est située en vis-à-vis de l'ensemble 136 d'aimants permanents de manière à ce que les lignes de champ magnétique de chacun de ces aimants permanents la traversent essentiellement horizontalement. Dans ces conditions, chaque aimant 142 à 145 crée une zone de déformation respective dans la couche 152 en vis-à-vis. Les zones de déformation créés par les aimants 142 à 145 sont numérotées, respectivement, de 156 à 159. Dans la position représentée sur la figure 9, les zones 156 et 158 tendent à s'allonger dans la direction Y sous l'effet du champ magnétique des aimants 142 et 144. L'allongement dans la direction Y correspond à un rétrécissement dans la direction X et donc à une contrainte en compression, le long de l'axe 154, exercée sur le transducteur électromécanique situé sur cette zone. Cette contrainte en compression est représentée par le symbole « - » sur la figure 9. Dans le même temps, les zones 157 et 159 tendent à s'allonger dans la direction X sous l'effet du champ magnétique des aimants 143 et 145. Les zones 157 et 159 exercent donc une contrainte en tension, le long de l'axe 154, sur les transducteurs électromécaniques situés sur ces zones. Cette contrainte en tension est représentée par le symbole « + ». Pour simplifier la figure 9, les séparations entre les zones sont représentées par des lignes en pointillé parallèles à la direction Y. Toutefois, dans la réalité, la forme de ces lignes peut être plus complexe.

Des transducteurs électromécaniques distincts sont fixés sans aucun degré de liberté sur chacune des zones 156 à 159 pour transformer à la fois l'allongement et le rétrécissement simultanés de la couche 152 dans la direction X en une génération d'excédent de charges électriques. Ces transducteurs électromécaniques sont réalisés comme décrit dans les modes de réalisation précédents et ne sont pas décrits ici plus en détail.

Lorsque l'ensemble 136 est déplacé d'un pas égal à la largeur des aimants 142 à 145 sur la droite ou sur la gauche, le long de l'axe 140, les contraintes mécaniques exercées sur les transducteurs électromécaniques disposés sur les zones 156 à 159 changent de signe. Ainsi, après un déplacement d'un pas, les transducteurs électromécaniques qui étaient principalement soumis à une contrainte en tension se retrouvent principalement soumis à une contrainte en compression et vice versa. Le fonctionnement du générateur 130 se déduit donc de celui décrit dans le cas de l'ensemble 100 d'aimants permanents.

La figure 10 représente un générateur 170 d'électricité. Le générateur 170 est identique au générateur 2 sauf que :
- la source 4 d'énergie à récupérer est remplacée par une source 172 d'énergie à récupérer, et
- le récupérateur 6 d'énergie est remplacé par un récupérateur 174 d'énergie.

La source 172 est ici une source de chaleur dont la température varie au cours du temps. Cette source de chaleur chauffe sensiblement uniformément l'ensemble du convertisseur du récupérateur 174.

Le récupérateur 174 est identique au récupérateur 6 sauf que le convertisseur 20 est remplacé par un convertisseur 176. Le convertisseur 176 est identique au convertisseur 20 sauf que la couche 40 est remplacée par une couche 178 en matériau à mémoire de forme. Pour simplifier la figure 10, seul le convertisseur 176 a été représenté. Ici, il s'agit d'un matériau à mémoire de forme présentant un taux d'allongement, le long de son axe préférentiel de déformation, au moins supérieur à 0,5% ou 1 % en réponse à une variation de température de 10° ou de 20°C. L'axe préférentiel de déformation de la couche 178 est l'axe le long duquel l'amplitude de sa déformation est maximale. Cette couche 178 est alors configurée pour qu'en réponse à une augmentation de la température extérieure, elle se contracte le long d'un axe tel que l'axe 52 et, simultanément, se s'allonge le long d'un autre axe tel que l'axe 53. Pour cela, par exemple, l'axe préférentiel de déformation de la couche 178 est aligné sur l'axe 52 dans la première position. Pour plus d'informations sur les matériaux à mémoire de forme utilisables dans un tel convertisseur, il est possible de se référer aux articles A2 et A3.

Le fonctionnement du générateur 170 se déduit de celui du générateur 2.

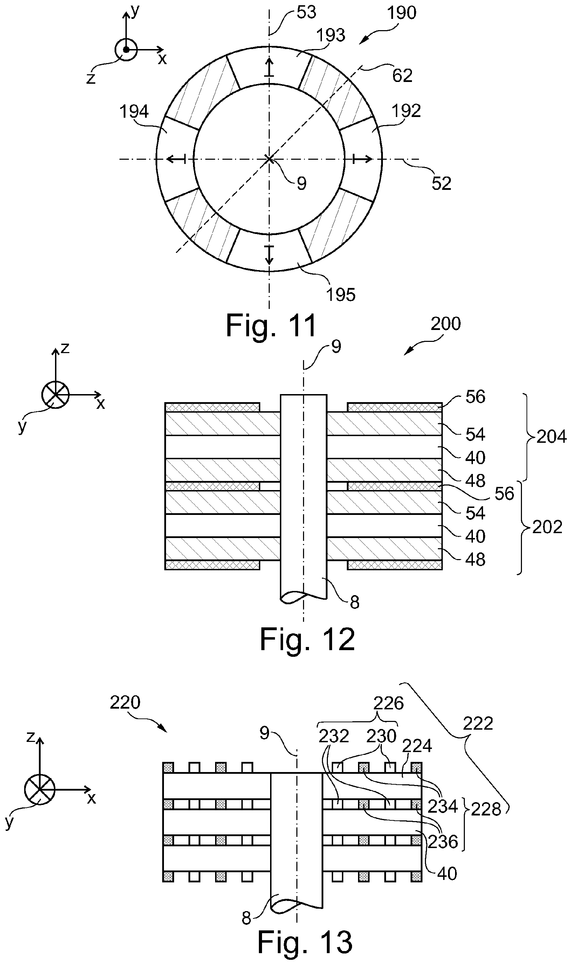

La figure 11 représente un ensemble 190 d'aimants permanents utilisable à la place de l'ensemble 92 de la figure 5. Dans ce mode de réalisation, l'ensemble 190 à la forme d'un anneau horizontal centré sur l'axe 9. L'ensemble 190 comporte quatre aimants permanents 192 à 195 uniformément répartis autour de l'axe 9. Chaque aimant 192 à 195 occupe un secteur angulaire respectif de l'anneau. Les secteurs angulaires occupés par les aimants 192 à 195 sont les mêmes que les secteurs occupés par les aimants 104, 106, 108 et 110 sur la figure 7. Les secteurs angulaires entre ces aimants 192 à 195 sont par exemple dépourvus d'aimant permanent. Ces secteurs angulaires dépourvus d'aimant permanent sont hachurés sur la figure 11. De préférence, lorsque l'ensemble 190 est utilisé, la couche 40 est également conformée en anneau ayant les mêmes diamètres intérieur et extérieur que l'ensemble 190.

La figure 12 représente un convertisseur 200 susceptible d'être utilisé à la place du convertisseur 20. Le convertisseur 200 résulte de l'assemblage, l'un au-dessus de l'autre, dans la direction verticale, de plusieurs exemplaires du convertisseur 20. Pour simplifier la figure 12, seuls deux exemplaires 202 et 204 sont représentés. Plus précisément, ces exemplaires sont empilés les uns au-dessus des autres de manière à ce que les transducteurs 42 de chaque exemplaire soient situés les uns au-dessus des autres dans la direction verticale. Dans ces conditions, chaque transducteur 42 est fixé au-dessus et en-dessous d'une zone 39 respective dans la position de la figure 2B. De préférence, l'électrode extérieure 56 de l'exemplaire 202 remplit également la fonction d'électrode pour la couche 48 de l'exemplaire 204.

Lors de l'utilisation du convertisseur 200, toutes les électrodes 56 et leurs symétriques par rapport à un plan médian de la couche 40 génèrent en même temps des charges électriques de même signe. Ainsi, de préférence, l'ensemble de ces électrodes sont électriquement raccordées directement à la même borne 22. De même l'ensemble des couches 40 sont électriquement raccordées directement à la borne 24. Le convertisseur 200 présente alors une meilleure efficacité par rapport au convertisseur 20.

Jusqu'à présent seul le mode d₃₁ des couches en matériau piézoélectrique a été utilisé. La figure 13 représente un convertisseur 220 susceptible d'être utilisé à la place du convertisseur 20 mais dans lequel c'est le mode d₃₃ des couches en matériau piézoélectrique qui est utilisé. Le convertisseur 220 est identique au convertisseur 20 sauf que les transducteurs électromécaniques sont remplacés par d'autres transducteurs électromécaniques de même forme et agencés les uns par rapport aux autres comme décrit en référence aux figures 2A, 2B et 3. Ainsi, ici, seul un transducteur 222 remplaçant le transducteur 42 est décrit plus en détail.

Le transducteur 222 est réalisé comme décrit en référence à la figure 3 de l'article A1 précédemment cité. Autrement dit, le transducteur 222 comporte une couche 224 en matériau piézoélectrique polarisé parallèlement à la direction X dans la position représentée sur la figure 13. Cette couche 224 est par exemple formée par la juxtaposition, dans un plan horizontal, parallèlement les unes aux autres de fibres en PZT s'étendant dans la direction X et polarisées dans cette direction. Chaque électrode 226, 228 du transducteur 222 est formée d'un ou plusieurs peignes. Chaque peigne est composé de plusieurs doigts en matériau électriquement conducteur s'étendant chacun parallèlement à la direction Y sur une face de la couche 224. Chaque peigne de l'électrode 226 est entrelacé ou « interdigité » avec un peigne correspondant de l'électrode 228 pour former une configuration connue sous le terme anglais de « Intedigitated combs ». Ici, l'électrode 226 comporte deux peignes 230, 232 disposés, respectivement, sur les faces extérieure et intérieure de la couche 224. De même, l'électrode 228 comporte deux peignes 234, 236 disposés, respectivement, sur les faces extérieure et intérieure de la couche 224. Le peigne 230 est entrelacé avec le peigne 234 et le peigne 232 est entrelacé avec le peigne 236.

Les autres transducteurs disposés sur les zones 37 à 39 se déduisent du transducteur 222 par une rotation autour de l'axe 9 de, respectivement, 90°, 180° et 270°. Ainsi, dans ce mode de réalisation, les directions de polarisation de ces transducteurs sont alignées le long des axes 52 et 53 dans la première position. De plus, les électrodes des transducteurs alignés sur l'axe 52 dans la première position sont électriquement isolées des électrodes des transducteurs alignés sur l'axe 53 dans cette même position.

Le fonctionnement du générateur 2 équipé du convertisseur 220 se déduit de ce qui a été précédemment expliqué lorsque le générateur est équipé du convertisseur 20.

De nombreux autres modes de réalisation sont possibles. Par exemple, les transducteurs électromécaniques ne sont formés que sur une partie des zones de déformation de la couche 40 ou 152. A titre d'illustration, on peut donc former un transducteur électromécanique uniquement sur la moitié des zones de déformation marquées par le symbole « + » sur la figure 6 et sur la moitié des zones de déformation marquées par le symbole « - » sur cette même figure 6.

D'autres matériaux piézoélectriques que le PZT ou le PMN-PT peuvent être utilisés pour réaliser les transducteurs électromécaniques. En pratique, on désigne ici par matériau piézoélectrique tout matériau capable de transformer une contrainte mécanique en un excédent de charges électriques sur l'une de ses faces horizontales. Par exemple, le matériau PZT peut être remplacé par du PVDF (Polyfluorure de Vinylidène). De préférence, l'épaisseur « e » de la couche 54 en PVDF est inférieure à 300 µm et avantageusement inférieure à 30 µm ou 40 µm. Généralement l'épaisseur « e » est supérieure à 10 µm. En effet, le choix du PVDF comme matériau piézoélectrique avec une épaisseur inférieure à 300 µm, dans l'agencement décrit ici du convertisseur 20, permet d'augmenter l'efficacité du convertisseur. Le matériau PZT peut aussi être remplacé par une mousse piézoélectrique telle que l'une de celles décrites dans l'article suivant :
Imran Patel, « *Ceramic based intelligent piezoelectric energy harversting device »,* Intechopen, 6 septembre 2011.

Une partie des transducteurs peut être fixée sur la face de dessus de la couche 40 tandis qu'une autre partie des transducteurs est fixée sur la face de dessous. Par exemple, seuls les transducteurs 72, 74 sont fixés sur la face de dessus de la couche 40 et seules les symétriques des transducteurs 73 et 75 sont fixés sur la face de dessous de la couche 40. Cela permet d'avoir sur chaque face de la couche 40 uniquement des transducteurs électromécaniques qui génèrent des charges du même signe.

Dans une autre variante, les transducteurs électromécaniques ne sont fixés que d'un seul côté de la couche 40.

De préférence, la couche en matériau piézoélectrique s'étend sur plus de 80 % ou 90 % de la zone de déformation dans la première position. Dans la première position, elle peut aussi s'étendre un peu au-delà de cette zone de déformation. Toutefois, dans tous les cas, la majeure partie de la couche en matériau piézoélectrique est fixée sur cette zone de déformation dans la première position.

Les modes de réalisation des figures 2A et 4 peuvent être combinés. Dans ce cas, des cloisons isolent mécaniquement les couches piézoélectriques et des séparations isolent mécaniquement les électrodes de chaque transducteur. Dans ce dernier cas, les couches piézoélectriques des transducteurs 43 et 45 peuvent être polarisées dans le même sens que les couches en matériau piézoélectrique des transducteurs 42 et 44. Dans ce dernier mode de réalisation, le raccordement électrique aux bornes 22 et 24 se fait comme décrit pour le mode de réalisation de la figure 4.

Dans le mode de réalisation des figures 1 à 3, les cloisons 58, 60, 61 et 63 peuvent être omises. En effet, il est possible de polariser différents secteurs d'une même couche en matériau piézoélectrique dans des sens opposés sans pour cela avoir recours à des cloisons séparant électriquement et mécaniquement ces secteurs.

Les électrodes des transducteurs qui génèrent systématiquement et simultanément des charges électriques de même signe n'ont pas besoin d'être isolées mécaniquement les unes des autres par des séparations. Par exemple, l'électrode 80 peut également s'étendre au-dessus de la couche en matériau piézoélectrique du transducteur 74 pour former en plus l'électrode de ce dernier transducteur. Cela ne pose pas de problème car les transducteurs 72 et 74 sont alignés le long du même axe de déformation et ont une même direction de polarisation de sorte qu'ils génèrent des charges de même signe en réponse aux mêmes déformations de la couche 40.

En variante, une électrode intérieure en matériau électriquement conducteur est interposée entre les couches 40 et 54. Cela s'avère nécessaire dans tout mode de réalisation où la couche 40 ou 178 est réalisée dans un matériau qui n'est pas électriquement conducteur.

Les électrodes extérieures ne sont pas nécessairement directement fixées sur la couche en matériau piézoélectrique. Par exemple, elles peuvent être séparées de cette couche par une fine couche intermédiaire. Typiquement, l'épaisseur de cette fine couche intermédiaire est inférieure à 1/100 ou à 1/1000 de l'épaisseur de la couche piézoélectrique. Elles peuvent également être légèrement mobiles par rapport à la couche en matériau piézoélectrique.

En variante, toutes les électrodes sont placées sur une même face de la couche en matériau piézoélectrique. Par exemple, les peignes 232, 236 sont omis et, alternativement, les peignes 230, 234 sont omis. En variante aussi, il est possible de conserver seulement les peignes 232 et 234 par exemple.

La couche 40 ou 178 n'est pas nécessairement formée d'un seul bloc de matière. En variante, la couche 40 ou 178 est formée par la juxtaposition de petits blocs de matériau magnétostrictif ou à mémoire de forme assemblés sans aucun degré de liberté les uns aux autres pour former une couche qui se comporte mécaniquement comme la couche en un seul bloc de matière.

Le matériau magnétostrictif peut aussi être remplacé par un alliage à mémoire de forme magnétique tel que le NiMnGa, c'est-à-dire un matériau qui travaille comme décrit pour les précédents matériaux à mémoire de forme sauf que la déformation est déclenchée par une variation du champ magnétique et non pas par une variation de température.

La forme du transducteur capable de transformer la variation de l'énergie à récupérer en une variation de contrainte mécanique peut être différente d'un disque. Par exemple, dans un autre mode de réalisation avantageux, la couche 40 à la forme d'une ellipse ou d'un anneau. Dans d'autres variantes, la couche 40 peut être un carré, un rectangle ou un polygone à plus de quatre sommets.

Le convertisseur 20 peut être monté en bout d'arbre sans qu'il soit transpercé en son centre par l'arbre 8.

La rotation du champ magnétique par rapport au convertisseur peut aussi être obtenue en faisant tourner l'ensemble d'aimants dans le repère XYZ plutôt que le convertisseur. Cela peut simplifier la connectique.

Ce qui a été décrit dans le cas d'un mouvement de rotation du convertisseur par rapport à un aimant permanent s'applique également au cas où le champ magnétique variable est généré par la translation d'un aimant permanent. Le champ magnétique variable peut également être généré par une bobine dans laquelle circule un courant d'intensité variable.

D'autres directions des moments magnétiques des ensembles d'aimants permanents sont possibles. Par exemple, dans l'ensemble 136 la direction des moments magnétiques des aimants 142 et 144 est inclinée, dans le plan horizontal, de +45° par rapport à l'axe 140 tandis que la direction des moments magnétiques des aimants 143 et 145 est inclinée de -45°, dans le plan horizontal, par rapport au même axe 140.

L'ensemble d'aimants permanents peut comporter beaucoup plus d'aimants permanents que ce qui a été représenté. Par exemple, ce nombre d'aimants permanents peut être supérieur à dix ou quarante notamment dans les modes de réalisation des figures 9 et 11.

Selon la nature de l'énergie à récupérer, d'autres transducteurs qu'une couche en matériau magnétostrictif peuvent être utilisés. Par exemple, si l'énergie à récupérer est une variation de température, la couche en matériau magnétostrictif est remplacée par une couche en matériau à mémoire de forme. Dans ce cas, pour faire varier la température de la couche en matériau à mémoire de forme, il n'est pas nécessaire que la source de chaleur se déplace. Elle peut être fixe par rapport à la couche en matériau à mémoire de forme et seule sa température varie. Dans le cas où, la couche 152 en matériau magnétostrictif est remplacée par une couche en matériau à mémoire de forme dont l'axe préférentiel de déformation est confondu avec l'axe 154, pour obtenir le même fonctionnement du récupérateur, l'ensemble 136 d'aimants permanents est remplacé par une source anisotrope de chaleur. La source anisotrope de chaleur est par exemple obtenue en remplaçant chaque aimant de l'ensemble 136 par un fin tuyau ou filament aligné sur le moment magnétique de l'aimant qu'il remplace. Ainsi, dans la position de la figure 9, le tuyau ou le filament en face de la zone 156 est perpendiculaire à l'axe 154 de sorte que cette zone s'allonge peu dans la direction X. A l'inverse, le tuyau ou le filament en face de la zone 157 est parallèle à l'axe 154 de sorte que cette zone s'allonge beaucoup plus dans la direction X.

L'appareil 10 peut être un roulement mécanique. Dans ce cas, l'axe 8 est l'axe de ce roulement et le châssis 14 est le châssis du roulement.

## Revendications

1. Un convertisseur d'une variation d'énergie à récupérer en une différence de potentiels, ce convertisseur comportant :
- un premier transducteur comportant une couche (40 ; 152 ; 178) s'étendant essentiellement dans un plan, dit de référence, et se comportant mécaniquement comme un seul bloc de matière, cette couche étant apte à s'allonger à l'intérieur d'au moins une première zone (36, 38 ; 157, 159) de déformation du plan de référence et, simultanément, à rétrécir à l'intérieur d'au moins une seconde zone (37, 39 ; 156, 158) de déformation du plan de référence distincte de la première zone, en réponse à la même variation d'énergie à récupérer,
- un deuxième et un troisième transducteurs électromécaniques (42-45 ; 72-75 ; 222), chaque transducteur électromécanique comportant :
• une couche (54 ; 78 ; 224) en matériau piézoélectrique s'étendant essentiellement parallèlement au plan de référence et présentant des faces intérieure et extérieure s'étendant parallèlement à ce plan, la face intérieure étant fixée sans aucun degré de liberté sur la couche du premier transducteur pour subir une contrainte mécanique exercée par l'une des zones de cette couche, et
• une première (56 ; 80 ; 226) et une deuxième (40 ; 228) électrodes en matériau électriquement conducteur s'étendant essentiellement parallèlement au plan de référence le long d'au moins l'une des faces de la couche en matériau piézoélectrique du deuxième transducteur pour faire apparaître un excédent de charges électriques sur l'une de ces électrodes en réponse à la contrainte mécanique subie par la couche en matériau piézoélectrique, dans lequel les faces intérieures des deuxième et troisième transducteurs électromécaniques sont fixées sans aucun degré de liberté essentiellement sur, respectivement, les première et seconde zones de déformation de la couche du premier transducteur, et le troisième transducteur se distingue du deuxième transducteur par une polarisation de sa couche en matériau piézoélectrique dans une direction différente de la polarisation de la couche en matériau piézoélectrique du deuxième transducteur et/ou par l'existence d'une séparation (82-85) isolant mécaniquement et électriquement sa première électrode de la première électrode du deuxième transducteur située du même côté de la couche en matériau piézoélectrique.

2. Le convertisseur selon la revendication 1, dans lequel :
- les faces intérieures des deuxième et troisième transducteurs (42-45 ; 72-75) sont fixées sans aucun degré de liberté sur une même face de la couche du premier transducteur parallèlement au plan de référence,
- les polarisation des couches en matériau piézoélectrique des deuxième et troisième transducteurs sont en sens inverse l'une de l'autre de sorte que les deuxième et troisième transducteurs génèrent, en même temps, des charges électriques de même signe sur leurs premières électrodes respectives en réponse à la même variation de l'énergie à récupérer, et
- les premières électrodes (56) sont électriquement raccordées l'une à l'autre pour former une électrode commune sur laquelle s'accumulent les charges électriques générées simultanément à la fois par le deuxième et le troisième transducteurs.

3. Le convertisseur selon la revendication 2, dans lequel les premières électrodes (56) comprennent une couche en matériau électriquement conducteur d'un seul bloc directement déposée sur les faces extérieures des couches en matériau piézoélectrique des deuxième et troisième transducteurs (42-45) et qui recouvre la majorité des faces extérieures de ces deux couches en matériau piézoélectrique de manière à former une électrode commune aux deuxième et troisième transducteurs électromécaniques.

4. Le convertisseur selon la revendication 2 ou 3, dans lequel le convertisseur comporte un quatrième transducteur comportant une couche s'étendant essentiellement dans un plan parallèle au plan de référence et se comportant mécaniquement comme un seul bloc de matière, cette couche étant apte à s'allonger à l'intérieur d'au moins une première zone de déformation parallèle au plan de référence et, simultanément, à rétrécir à l'intérieur d'au moins une seconde zone de déformation parallèle au plan de référence distincte de la première zone, en réponse à la même variation d'énergie à récupérer, les première et seconde zones de déformation de la couche du quatrième transducteur étant en vis-à-vis, respectivement, des première et seconde zones de déformation de la couche du premier transducteur, et les faces extérieures des couches en matériau piézoélectrique des deuxième et troisième transducteurs sont fixées sans aucun degré de liberté essentiellement sur, respectivement, les première et seconde zones de déformation de la couche du quatrième transducteur.

5. Le convertisseur selon l'une quelconque des revendications précédentes, dans lequel le convertisseur comporte une cloison (58, 60, 61, 63) qui isole mécaniquement les couches en matériau piézoélectrique des deuxième et troisième transducteurs (42-45), la largeur de cette cloison sur la majorité de sa longueur située entre les deuxième et troisième transducteurs étant inférieure à l'épaisseur de la couche en matériau piézoélectrique de ces deuxième et troisième transducteurs.

6. Le convertisseur selon l'une quelconque des revendications précédentes, dans lequel le matériau piézoélectrique est du PVDF (Polyfluorure de vinylidène) et l'épaisseur de la couche en matériau piézoélectrique est inférieure à 300 µm.

7. Le convertisseur selon l'une quelconque des revendications précédentes, dans lequel la couche du premier transducteur présente des faces opposées de dessus et de dessous parallèles au plan de référence et des exemplaires (42-45 ; 48, 50) du deuxième et troisième transducteurs sont répartis sur chacune des deux faces opposées de la couche du premier transducteur de façon symétrique par rapport à un plan de symétrie parallèle au plan de référence et situé entre les deux faces opposées du premier transducteur.

8. Le convertisseur selon la revendication 1, dans lequel :
- les faces intérieures des deuxième et troisième transducteurs (72-75) sont fixées sans aucun degré de liberté sur une même face de la couche du premier transducteur parallèle au plan de référence,
- les directions de polarisation des couches en matériau piézoélectrique des deuxième et troisième transducteurs (72-75) sont parallèles et de même sens de sorte que les deuxième et troisième transducteurs génèrent en même temps des charges électriques de signe opposé, respectivement, sur leurs premières électrodes respectives en réponse à la même déformation du premier transducteur,
- la séparation (82-85) isole mécaniquement et électriquement les premières électrodes l'une de l'autre de manière à générer entre ces premières électrodes une différence de potentiels plus grande que celle existante entre les faces intérieures et extérieures des couches piézoélectriques de chacun de ces transducteurs électromécaniques.

9. Le convertisseur selon l'une quelconque des revendications précédentes, dans lequel :
- les faces intérieures des deuxième et troisième transducteurs (222) sont fixées sans aucun degré de liberté sur une même face de la couche du premier transducteur parallèlement au plan de référence,
- les polarisation des couches en matériau piézoélectrique des deuxième et troisième transducteurs sont parallèles au plan de référence et décalées angulairement l'une par rapport à l'autre de manière à ce que les deuxième et troisième transducteurs génèrent, en même temps, des charges électriques de signe opposé sur leurs premières électrodes respectives en réponse à la même variation de l'énergie à récupérer, et
- la séparation isole mécaniquement et électriquement les premières électrodes (226) l'une de l'autre de manière à générer entre ces premières électrodes une différence de potentiels.

10. Le convertisseur selon l'une quelconque des revendications précédentes, dans lequel la couche (40; 152) du premier transducteur est réalisée en matériau magnétostrictif, cette couche en matériau magnétostrictif étant apte à s'allonger à l'intérieur de la première zone de déformation et, simultanément, à se raccourcir à l'intérieur de la seconde zone de déformation en réponse à une même variation d'un champ magnétique.

11. Le convertisseur selon l'une quelconque des revendications 1 à 9, dans lequel la couche (178) du premier transducteur est réalisée en matériau à mémoire de forme, cette couche en matériau à mémoire de forme étant apte à s'allonger à l'intérieur de la première zone de déformation et, simultanément, à se raccourcir à l'intérieur de la seconde zone de déformation en réponse à une même variation de température ou de champ magnétique.

12. Un générateur d'électricité comportant :
- une source (4) de champ magnétique variable, et
- un convertisseur (20 ; 90 ; 220) apte à convertir une variation du champ magnétique de la source de champ magnétique en une différence de potentiels, **caractérisé en ce que** :
- le convertisseur est conforme à la revendication 10, et
- la source de champ magnétique est apte à générer simultanément, à l'intérieur de la couche du premier transducteur, les première et seconde zones de déformation.

13. Le générateur selon la revendication 12, dans lequel :
- la source de champ magnétique variable contient au moins un aimant permanent (12 ; 104-111 ; 124-127 ; 142-145), et
- le convertisseur est déplaçable par rapport à cet aimant permanent entre :
• une première position dans laquelle une seule des première et seconde zones de déformation est en vis-à-vis de l'aimant permanent, et
• une deuxième position dans laquelle l'autre de ces première et deuxième zones de déformation est en vis-à-vis de l'aimant permanent.

14. Le générateur selon la revendication 13, dans lequel la source comporte au moins un premier aimant permanent (104, 106, 108, 110 ; 124, 126 ; 143, 145) ayant un premier moment magnétique et un second aimant permanent (105, 107, 109, 111 ; 125, 127 ; 156 ; 159) ayant un second moment magnétique, les premier et second aimants permanents étant fixés sans aucun degré de liberté l'un à l'autre, et les projections orthogonales, dans le plan de référence, des moments magnétiques des premier et second aimants permanents sont décalées angulairement l'une par rapport à l'autre de 90° à plus ou moins 20° près.

15. Le générateur selon la revendications 13, dans lequel :
- la couche du premier transducteur à la forme d'un disque ou d'un anneau centré sur un axe de révolution,
- chaque première (36, 38) et seconde (37, 29) zones de déformation sont des secteurs angulaires distincts de ce disque ou de cet anneau,
- au moins l'un de l'aimant permanent et du premier transducteur est monté en rotation autour de l'axe de révolution.

## Patentansprüche

1. Wandler zum Umwandeln einer Änderung von rückzugewinnender Energie in eine Potenzialdifferenz, wobei dieser Wandler aufweist:
- einen ersten Messwandler, der eine Schicht (40; 152; 178) aufweist, die sich im Wesentlichen in einer Ebene, Referenzebene genannt, erstreckt und sich mechanisch wie ein einziger Materialblock verhält, wobei diese Schicht in der Lage ist, in Reaktion auf dieselbe Änderung von rückzugewinnender Energie sich innerhalb wenigstens eines ersten Verformungsbereichs (36, 38; 157, 159) der Referenzebene zu dehnen und sich gleichzeitig innerhalb wenigstens eines zweiten Verformungsbereichs (37, 39; 156, 158) der Referenzebene, der von dem ersten Bereich verschieden ist, zusammenzuziehen,
- einen zweiten und einen dritten elektromechanischen Messwandler (42-45; 72-75; 222), wobei jeder elektromechanische Messwandler aufweist:
• eine Schicht (54; 78; 224) aus piezoelektrischem Material, die sich im Wesentlichen parallel zu der Referenzebene erstreckt und eine Innenseite und eine Außenseite aufweist, die sich parallel zu dieser Ebene erstrecken, wobei die Innenseite ohne Freiheitsgrad an der Schicht des ersten Messwandlers befestigt ist, um einer mechanischen Beanspruchung ausgesetzt zu werden, die durch einen der Bereiche dieser Schicht ausgeübt wird, und
• eine erste (56; 80; 226) und eine zweite (40; 228) Elektrode aus elektrisch leitendem Material, die sich im Wesentlichen parallel zu der Referenzebene entlang wenigstens einer der Seiten der Schicht aus piezoelektrischem Material des zweiten Messwandlers erstrecken, um in Reaktion auf die mechanische Beanspruchung, der die Schicht aus piezoelektrischem Material ausgesetzt ist, einen Überschuss an elektrischen Ladungen hervortreten zu lassen,
wobei die Innenseiten des zweiten und des dritten elektromechanischen Messwandlers ohne Freiheitsgrad im Wesentlichen auf dem ersten bzw. zweiten Verformungsbereich der Schicht des ersten Messwandlers befestigt sind und der dritte Messwandler sich von dem zweiten Messwandler durch eine Polarisation seiner Schicht aus piezoelektrischem Material in einer Richtung, die von der Polarisation der Schicht aus piezoelektrischem Material des zweiten Messwandlers verschieden ist, und/oder durch das Vorhandensein einer mechanisch und elektrisch isolierenden Trennung (82-85) seiner ersten Elektrode von der ersten Elektrode des zweiten Messwandlers, die sich auf derselben Seite der Schicht aus piezoelektrischem Material befindet, unterscheidet.

2. Wandler nach Anspruch 1, wobei:
- die Innenseiten des zweiten und des dritten Messwandlers (42-45; 72-75) ohne Freiheitsgrad auf ein und derselben Seite der Schicht des ersten Messwandlers parallel zur Referenzebene befestigt sind,
- die Polarisation der Schichten aus piezoelektrischem Material des zweiten und dritten Messwandlers in zueinander entgegengesetzten Richtungen vorliegt, so dass der zweite und der dritte Messwandler in Reaktion auf dieselbe Änderung der rückzugewinnenden Energie gleichzeitig elektrische Ladungen mit demselben Vorzeichen auf ihren jeweiligen ersten Elektroden erzeugen, und
- die ersten Elektroden (56) elektrisch aneinander angeschlossen sind, um eine gemeinsame Elektrode zu bilden, auf welcher sich die elektrischen Ladungen ansammeln, die gleichzeitig vom zweiten und vom dritten Messwandler erzeugt werden.

3. Wandler nach Anspruch 2, wobei die ersten Elektroden (56) eine Schicht aus elektrisch leitendem Material in einem einzigen Block umfassen, welche direkt auf die Außenseiten der Schichten aus piezoelektrischem Material des zweiten und des dritten Messwandlers (42-45) aufgebracht ist und welche den größten Teil der Außenseiten dieser zwei Schichten aus piezoelektrischem Material bedeckt, um eine Elektrode zu bilden, die dem zweiten und dem dritten elektromechanischen Messwandler gemeinsam ist.

4. Wandler nach Anspruch 2 oder 3, wobei der Wandler einen vierten Messwandler aufweist, der eine Schicht aufweist, die sich im Wesentlichen in einer zur Referenzebene parallelen Ebene erstreckt und sich mechanisch wie ein einziger Materialblock verhält, wobei diese Schicht in der Lage ist, in Reaktion auf dieselbe Änderung von rückzugewinnender Energie sich innerhalb wenigstens eines ersten Verformungsbereichs, der zur Referenzebene parallel ist, zu dehnen und sich gleichzeitig innerhalb wenigstens eines zweiten Verformungsbereichs, der zur Referenzebene parallel ist und von dem ersten Bereich verschieden ist, zusammenzuziehen, wobei sich der erste und der zweite Verformungsbereich der Schicht des vierten Messwandlers gegenüber dem ersten bzw. zweiten Verformungsbereich der Schicht des ersten Messwandlers befinden und die Außenseiten der Schichten aus piezoelektrischem Material des zweiten und des dritten Messwandlers ohne Freiheitsgrad im Wesentlichen auf dem ersten bzw. zweiten Verformungsbereich der Schicht des vierten Messwandlers befestigt sind.

5. Wandler nach einem der vorhergehenden Ansprüche, wobei der Wandler eine Trennwand (58, 60, 61, 63) aufweist, welche die Schichten aus piezoelektrischem Material des zweiten und des dritten Messwandlers (42-45) mechanisch isoliert, wobei die Breite dieser Trennwand auf dem größten Teil ihrer zwischen dem zweiten und dem dritten Messwandler befindlichen Länge kleiner als die Dicke der Schicht aus piezoelektrischem Material dieses zweiten und dieses dritten Messwandlers ist.

6. Wandler nach einem der vorhergehenden Ansprüche, wobei das piezoelektrische Material PVDF (Polyvinylidenfluorid) ist und die Dicke der Schicht aus piezoelektrischem Material kleiner als 300 µm ist.

7. Wandler nach einem der vorhergehenden Ansprüche, wobei die Schicht des ersten Messwandlers eine obere und eine untere Seite aufweist, die einander gegenüberliegen und zur Referenzebene parallel sind, und Exemplare (42-45; 48, 50) des zweiten und des dritten Messwandlers auf jeder der beiden gegenüberliegenden Seiten der Schicht des ersten Messwandlers symmetrisch bezüglich einer Symmetrieebene, die zur Referenzebene parallel ist und sich zwischen den zwei gegenüberliegenden Seiten des ersten Messwandlers befindet, verteilt sind.

8. Wandler nach Anspruch 1, wobei:
- die Innenseiten des zweiten und des dritten Messwandlers (72-75) ohne Freiheitsgrad auf ein und derselben Seite der Schicht des ersten Messwandlers parallel zur Referenzebene befestigt sind,
- die Polarisationsrichtungen der Schichten aus piezoelektrischem Material des zweiten und dritten Messwandlers (72-75) parallel und gleichgerichtet sind, so dass der zweite und der dritte Messwandler in Reaktion auf dieselbe Verformung des ersten Messwandlers gleichzeitig elektrische Ladungen mit entgegengesetztem Vorzeichen auf ihren jeweiligen ersten Elektroden erzeugen,
- die Trennung (82-85) die ersten Elektroden mechanisch und elektrisch voneinander isoliert, um zwischen diesen ersten Elektroden eine Potenzialdifferenz zu erzeugen, die größer als diejenige ist, die zwischen den Innenseiten und Außenseiten der piezoelektrischen Schichten jedes dieser elektromechanischen Messwandler vorhanden ist.

9. Wandler nach einem der vorhergehenden Ansprüche, wobei:
- die Innenseiten des zweiten und des dritten Messwandlers (222) ohne Freiheitsgrad auf ein und derselben Seite der Schicht des ersten Messwandlers parallel zur Referenzebene befestigt sind,
- die Polarisationsrichtungen der Schichten aus piezoelektrischem Material des zweiten und dritten Messwandlers parallel zur Referenzebene und winkelversetzt zueinander sind, derart, dass der zweite und der dritte Messwandler in Reaktion auf dieselbe Änderung der rückzugewinnenden Energie gleichzeitig elektrische Ladungen mit entgegengesetztem Vorzeichen auf ihren jeweiligen ersten Elektroden erzeugen, und
- die Trennung die ersten Elektroden (226) mechanisch und elektrisch voneinander isoliert, um zwischen diesen ersten Elektroden eine Potenzialdifferenz zu erzeugen.

10. Wandler nach einem der vorhergehenden Ansprüche, wobei die Schicht (40; 152) des ersten Messwandlers aus magnetostriktivem Material hergestellt ist, wobei diese Schicht aus magnetostriktivem Material in der Lage ist, in Reaktion auf ein und dieselbe Änderung eines Magnetfeldes sich innerhalb des ersten Verformungsbereichs zu dehnen und sich gleichzeitig innerhalb des zweiten Verformungsbereichs zusammenzuziehen.

11. Wandler nach einem der Ansprüche 1 bis 9, wobei die Schicht (178) des ersten Messwandlers aus Formgedächtnismaterial hergestellt ist, wobei diese Schicht aus Formgedächtnismaterial in der Lage ist, in Reaktion auf ein und dieselbe Änderung einer Temperatur oder eines Magnetfeldes sich innerhalb des ersten Verformungsbereichs zu dehnen und sich gleichzeitig innerhalb des zweiten Verformungsbereichs zusammenzuziehen.

12. Stromgenerator, welcher aufweist:
- eine Quelle (4) eines variablen Magnetfeldes, und
- einen Wandler (20; 90; 220), der in der Lage ist, eine Änderung des Magnetfeldes der Magnetfeldquelle in eine Potenzialdifferenz umzuwandeln, **dadurch gekennzeichnet, dass**:
- der Wandler ein Wandler nach Anspruch 10 ist, und
- die Magnetfeldquelle in der Lage ist, innerhalb der Schicht des ersten Wandlers gleichzeitig den ersten und den zweiten Verformungsbereich zu erzeugen.

13. Generator nach Anspruch 12, wobei:
- die Quelle eines variablen Magnetfeldes wenigstens einen Permanentmagneten (12; 104-111; 124-127; 142-145) enthält, und
- der Wandler bezüglich dieses Permanentmagneten verlagerbar ist zwischen:
• einer ersten Position, in welcher sich einer der Verformungsbereiche, der erste oder der zweite, gegenüber dem Permanentmagneten befindet, und
• einer zweiten Position, in welcher sich der andere von diesen zwei Verformungsbereichen gegenüber dem Permanentmagneten befindet.

14. Generator nach Anspruch 13, wobei die Quelle wenigstens einen ersten Permanentmagneten (104, 106, 108, 110; 124, 126; 143, 145) mit einem ersten magnetischen Moment und einen zweiten Permanentmagneten (105, 107, 109, 111; 125, 127; 156; 159) mit einem zweiten magnetischen Moment aufweist, wobei der erste und der zweite Permanentmagnet ohne Freiheitsgrad aneinander befestigt sind und die orthogonalen Projektionen der magnetischen Momente des ersten und des zweiten Permanentmagneten in die Referenzebene um 90° plus/minus 20° winkelversetzt zueinander sind.

15. Generator nach Anspruch 13, wobei:
- die Schicht des ersten Messwandlers die Form einer Scheibe oder eines Ringes aufweist, die (der) bezüglich einer Rotationsachse zentriert ist,
- alle ersten (36, 38) und zweiten (37, 29) Verformungsbereiche unterschiedliche Winkelsektoren dieser Scheibe oder dieses Ringes sind,
- der Permanentmagnet und/oder der erste Messwandler um die Rotationsachse drehbar gelagert ist.

## Claims

1. Converter of a variation in energy to be harvested into a potential difference, this converter including:
- a first transducer including a layer (40; 152; 178) extending essentially in a plane, called a reference plane, and behaving mechanically as a single block of material, this layer being able to lengthen in the interior of at least one first zone (36, 38; 157, 159) of deformation of the reference plane and, simultaneously, to shrink in the interior of at least one second zone (37, 39; 156, 158) of deformation of the reference plane in response to a given variation in energy to be harvested, the second zone being distinct from the first zone; and
- electromechanical second and third transducers (42-45; 72-75; 222), each electromechanical transducer including:
• a layer (54; 78; 224) made of piezoelectric material extending essentially parallelly to the reference plane and having exterior and interior faces extending parallelly to this plane, the interior face being fixed with no degree of freedom to the layer of the first transducer in order to undergo a mechanical stress exerted by one of the zones of this layer; and
• first (56; 80; 226) and second (40; 228) electrodes made of electrically conductive material extending essentially parallelly to the reference plane along at least one of the faces of the layer made of piezoelectric material of the second transducer in order to cause an excess of electrical charges to appear on one of these electrodes in response to the mechanical stress undergone by the layer made of piezoelectric material,
in which the interior faces of the electromechanical second and third transducers are fixed with no degree of freedom essentially to the first and second zones of deformation of the layer of the first transducer, respectively, and the third transducer differs from the second transducer by a polarization of its layer made of piezoelectric material in a direction different from the polarization of the layer made of piezoelectric material of the second transducer and/or by the existence of a separation (82-85) mechanically and electrically insulating its first electrode from the first electrode of the second transducer, which electrode is located on the same side of the layer made of piezoelectric material.

2. Converter according to Claim 1, in which:
- the interior faces of the second and third transducers (42-45; 72-75) are fixed with no degree of freedom to the same face of the layer of the first transducer parallelly to the reference plane;
- the polarizations of the layers made of piezoelectric material of the second and third transducers have opposite signs to each other so that the second and third transducers generate, at the same time, electrical charges of the same sign on their respective first electrodes in response to a given variation in the energy to be harvested; and
- the first electrodes (56) are electrically connected to each other to form a common electrode on which the electrical charges generated simultaneously both by the second and third transducers accumulate.

3. Converter according to Claim 2, in which the first electrodes (56) comprise a layer made of electrically conductive material in a single block, which layer is deposited directly on the exterior faces of the layers made of piezoelectric material of the second and third transducers (42-45) and covers most of the exterior faces of these two layers made of piezoelectric material so as to form an electrode common to the electromechanical second and third transducers.

4. Converter according to Claim 2 or 3, in which the converter includes a fourth transducer including a layer extending essentially in a plane parallel to the reference plane and behaving mechanically as a single block of material, this layer being able to lengthen in the interior of at least one first zone of deformation parallel to the reference plane and, simultaneously, to shrink in the interior of at least one second zone of deformation parallel to the reference plane in response to a given variation in energy to be harvested, the second zone being distinct from the first zone and the first and second zones of deformation of the layer of the fourth transducer being directly opposite the first and second zones of deformation of the layer of the first transducer, respectively, and the exterior faces of the layers made of piezoelectric material of the second and third transducers are fixed with no degree of freedom essentially to the first and second zones of deformation of the layer of the fourth transducer, respectively.

5. Converter according to any one of the preceding claims, in which the converter includes a partition (58, 60, 61, 63) that mechanically insulates the layers made of piezoelectric material of the second and third transducers (42-45), the width of this partition over most of its length located between the second and third transducers being smaller than the thickness of the layer made of piezoelectric material of these second and third transducers.

6. Converter according to any one of the preceding claims, in which the piezoelectric material is PVDF (polyvinylidene fluoride) and the thickness of the layer made of piezoelectric material is smaller than 300 µm.

7. Converter according to any one of the preceding claims, in which the layer of the first transducer has opposite top and bottom faces parallel to the reference plane and specimens (42-45; 48, 50) of the second and third transducers are distributed over each of the two opposite faces of the layer of the first transducer symmetrically relative to a plane of symmetry parallel to the reference plane and located between the two opposite faces of the first transducer.

8. Converter according to Claim 1, in which:
- the interior faces of the second and third transducers (72-75) are fixed with no degree of freedom to the same face of the layer of the first transducer parallel to the reference plane;
- the polarization directions of the layers made of piezoelectric material of the second and third transducers (72-75) are parallel and of the same sign so that the second and third transducers generate at the same time electrical charges of opposite sign on their respective first electrodes in response to a given deformation of the first transducer, respectively; and
- the separation (82-85) mechanically and electrically insulates the first electrodes from each other so as to generate between these first electrodes a larger potential difference than that existing between the interior and exterior faces of the piezoelectric layers of each of these electromechanical transducers.

9. Converter according to any one of the preceding claims, in which:
- the interior faces of the second and third transducers (222) are fixed with no degree of freedom to the same face of the layer of the first transducer parallelly to the reference plane;
- the polarizations of the layers made of piezoelectric material of the second and third transducers are parallel to the reference plane and shifted angularly one relative to the other so that the second and third transducers generate, at the same time, electrical charges of opposite sign on their respective first electrodes in response to a given variation in the energy to be harvested; and
- the separation mechanically and electrically insulates the first electrodes (226) from each other so as to generate between these first electrodes a potential difference.

10. Converter according to any one of the preceding claims, in which the layer (40; 152) of the first transducer is produced from magnetostrictive material, this layer made of magnetostrictive material being able to lengthen in the interior of the first zone of deformation and, simultaneously, to shorten in the interior of the second zone of deformation in response to a given variation in a magnetic field.

11. Converter according to any one of Claims 1 to 9, in which the layer (178) of the first transducer is produced from shape-memory material, this layer made of shape-memory material being able to lengthen in the interior of the first zone of deformation and, simultaneously, to shorten in the interior of the second zone of deformation in response to a given variation in temperature or in magnetic field.

12. Generator of electricity including:
- a variable magnetic field source (4); and
- a converter (20; 90; 220) able to convert a variation in the magnetic field of the magnetic field source into a potential difference, **characterized in that**:
- the converter is according to claim 10; and
- the magnetic field source is able to generate simultaneously, in the interior of the layer of the first transducer, the first and second zones of deformation.

13. Generator according to Claim 12, in which:
- the variable magnetic field source contains at least one permanent magnet (12; 104-111; 124-127; 142-145); and
- the converter is movable relative to this permanent magnet between:
• a first position in which only one of the first and second zones of deformation directly faces the permanent magnet; and
• a second position in which the other of these first and second zones of deformation directly faces the permanent magnet.

14. Generator according to Claim 13, in which the source includes at least one first permanent magnet (104, 106, 108, 110; 124, 126; 143, 145) having a first magnetic moment and a second permanent magnet (105, 107, 109, 111; 125, 127; 156; 159) having a second magnetic moment, the first and second permanent magnets being fixed with no degree of freedom to each other, and the orthogonal projections, in the reference plane, of the magnetic moments of the first and second permanent magnets are angularly shifted relative to each other by 90° plus or minus 20°.

15. Generator according to Claim 13, in which:
- the layer of the first transducer has the shape of a disk or a ring centered on an axis of revolution;
- each first (36, 38) and second (37, 29) zones of deformation are distinct angular sectors of this disk or this ring; and
- at least one of the permanent magnet and of the first transducer is mounted so as to be able to rotate about the axis of revolution.
